# DEMANDE DE BREVET EUROPEEN

(11) **EP 4 482 286 A1**
(43) Date de publication de la demande: **25.12.2024**
(21) Numéro de dépôt: 24182672.6
(22) Date de dépôt: 17.06.2024
(51) Int. Cl.: H10N 70/20, H10N 70/00

(54) **DISPOSITIF ÉLECTRONIQUE COMPORTANT UNE COUCHE EN UN MATÉRIAU 2D**

(30) Priorité: 22.06.2023 FR 2306498
(71) Demandeur: Commissariat à l'Energie Atomique et aux Energies Alternatives, 75015 Paris (FR)
(72) Inventeur: LIGAUD, Clotilde, 38054 Grenoble Cedex 09 (FR); BRUNET, Paul, 38054 Grenoble Cedex 09 (FR); ROLLAND, Emmanuel, 38054 Grenoble Cedex 09 (FR); TROUSSET, Pierre, 38054 Grenoble Cedex 09 (FR)
(74) Mandataire: Cabinet Beaumont

(57) **Abrégé**

La présente description concerne un dispositif électronique comportant un empilement comportant, dans l'ordre à partir de la face supérieure d'un substrat (13), une première électrode (17), une couche d'un matériau 2D (25), et une deuxième électrode (27), dans lequel la surface supérieure et les flancs de la couche du matériau 2D (25) sont entièrement recouvertes par une couche d'encapsulation comprenant au moins la deuxième électrode (27) .

## Description

### Domaine technique

La présente description concerne de façon générale un dispositif électronique comportant une couche en un matériau 2D et plus particulièrement un dispositif électronique comportant une couche en un matériau 2D comprise entre deux couches conductrices.

### Technique antérieure

On appelle matériau 2D ou matériau bidimensionnel, un matériau constitué d'un feuillet monoatomique ou monomoléculaire unique, ou d'un empilement de plusieurs feuillets monoatomiques ou monomoléculaires superposés, sans liaison chimique entre deux feuillets adjacents. Autrement dit, on appelle matériau 2D un empilement d'un ou plusieurs plans cristallins de même nature, sans liaison chimique entre deux plans adjacents. Dans un tel matériau, les plans cristallins ou feuillets successifs sont liés uniquement par des liaisons de Van de Waals.

On s'intéresse ici plus particulièrement à des matériaux 2D présentant des propriétés de changement d'état, c'est-à-dire ayant la capacité de basculer d'un état relativement faiblement résistif à un état relativement fortement résistif, et inversement, sous l'effet d'une polarisation. Le changement d'état d'un matériau 2D peut être assuré par deux électrodes situées de part et d'autre du matériau 2D.

Des dispositifs électroniques incluant de tels matériaux peuvent tirer profit du changement d'état résistif pour mettre en oeuvre une fonction mémoire ou une fonction de commutation, par exemple une fonction de commutation de signaux radiofréquence.

### Résumé de l'invention

Un mode de réalisation pallie tout ou partie des inconvénients des dispositifs électroniques connus comportant une couche en un matériau 2D.

Un mode de réalisation prévoit un dispositif électronique comportant un empilement comportant, dans l'ordre à partir de la face supérieure d'un substrat, une première électrode, une couche d'un matériau 2D, et une deuxième électrode,
dans lequel la surface supérieure et les flancs de la couche du matériau 2D sont entièrement recouvertes par une couche d'encapsulation comprenant au moins la deuxième électrode.

Selon un mode de réalisation, la couche d'encapsulation (27) présente une face inférieure coplanaire avec une face inférieure de la couche du matériau 2D (25).

Selon un mode de réalisation, la couche d'encapsulation est constituée uniquement de la deuxième électrode.

Selon un mode de réalisation, le dispositif comprend, entre la couche en le matériau 2D et la première électrode, une couche isolante et un via conducteur traversant la couche isolante, le via conducteur étant en contact par une première face avec ladite couche en le matériau 2D et par une deuxième face, opposée à la première face, avec la première électrode.

Selon un mode de réalisation, la couche d'encapsulation comprend une couche isolante sur et au contact avec au moins une partie des flancs de la couche du matériau 2D.

Selon un mode de réalisation, la couche en le matériau 2D est en contact par une première face avec la couche d'encapsulation et par une deuxième face, opposée à la première face, avec la première électrode.

Selon un mode de réalisation, la deuxième électrode est en contact avec seulement une partie de la couche en le matériau 2D.

Selon un mode de réalisation, le matériau 2D est semiconducteur.

Selon un mode de réalisation, le matériau 2D est à base d'un dichalcogénure de métal de transition.

Selon un mode de réalisation, le matériau 2D est à base de disulfure de molybdène.

Selon un mode de réalisation, la couche en le matériau 2D correspond à un empilement de plusieurs monocouches de disulfure de molybdène et de graphène.

Selon un mode de réalisation, le matériau 2D est à base de nitrure de bore hexagonal.

Un autre mode de réalisation prévoit un procédé de fabrication d'un dispositif électronique comportant la formation d'un empilement comportant les étapes successives suivantes :
- former une première électrode sur la face supérieure d'un substrat ;
- former une couche d'un matériau 2D sur la face supérieure de la première électrode ; et
- former une deuxième électrode sur la face supérieure de la couche en le matériau 2D, de sorte que la face supérieure et les flancs de la couche du matériau 2D soient entièrement recouvertes par une couche d'encapsulation comprenant au moins la deuxième électrode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C représentent respectivement une vue de dessus et deux vues en coupe, partielles et schématiques, d'un dispositif électronique selon un premier mode de réalisation ;
la figure 2A et la figure 2B représentent respectivement une vue de dessus et une vue en coupe, partielles et schématiques, d'un dispositif électronique selon un deuxième mode de réalisation ;
la figure 3A et la figure 3B représentent respectivement une vue de dessus et une vue en coupe, partielles et schématiques, d'un dispositif électronique selon un troisième mode de réalisation ; et
la figure 4A, la figure 4B et la figure 4C représentent respectivement une vue de dessus et deux vues en coupe, partielles et schématiques, d'un dispositif électronique selon un quatrième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de contrôle des cellules mémoires ou des cellules de commutation décrites n'ont pas été détaillés, la réalisation de tels circuits de contrôles étant à la portée de la personne du métier à partir des enseignements de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

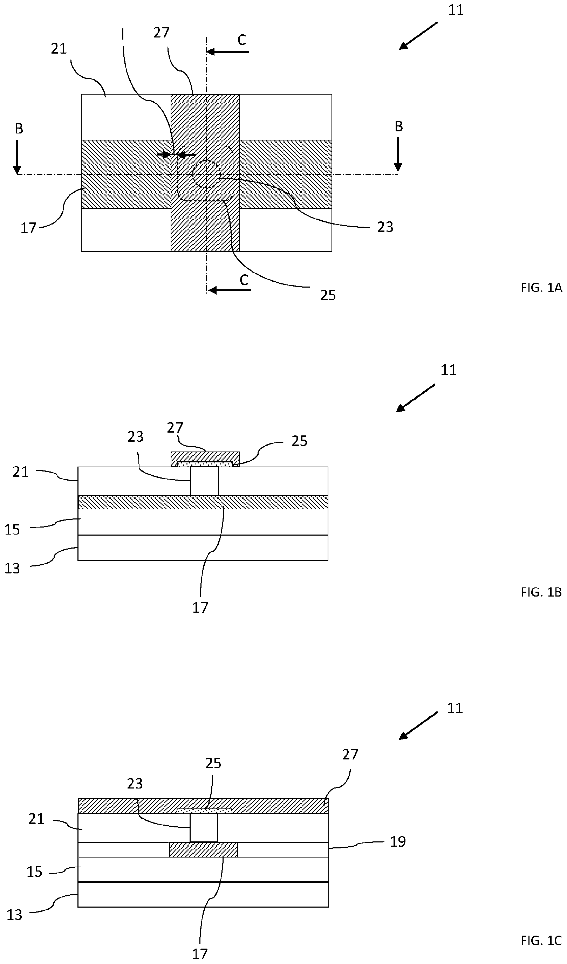

La figure 1A, la figure 1B et la figure 1C représentent respectivement une vue de dessus et deux vues en coupe, partielles et schématiques, d'un dispositif électronique 11 selon un premier mode de réalisation, la figure 1B correspondant à la vue en coupe selon le plan de coupe BB illustré en figure 1A et la figure 1C correspond à la vue en coupe selon plan de coupe CC illustré en figure 1A.

Le dispositif électronique 11 correspond, par exemple, à une cellule mémoire. En pratique, plusieurs cellules mémoires peuvent être formées côte à côte par exemple en formant un réseau ou une matrice comportant des lignes et des colonnes.

Le dispositif électronique 11 comprend, à partir d'une face inférieure, un substrat 13. A titre l'exemple, le substrat 13 est un substrat semiconducteur. Le substrat 13 est par exemple en un matériau semiconducteur de haute résistivité, par exemple de résistivité supérieure à 2,3.10³ Ω.m.. Le substrat 13 est par exemple en silicium.

Le dispositif électronique 11 comprend, par exemple, une couche isolante 15 revêtant la face supérieure du substrat 13. A titre d'exemple, la couche isolante 15 est en contact, par sa face inférieure avec la face supérieure du substrat 13. La couche isolante 15 recouvre, par exemple, toute la surface de la face supérieure du substrat 13. La couche isolante 15 est par exemple en un oxyde. La couche isolante 15 est par exemple en dioxyde de silicium (SiO₂).

Le dispositif électronique 11 comprend, de plus, une électrode inférieure 17 revêtant au moins une partie de la face supérieure de la couche isolante 15. A titre d'exemple, l'électrode inférieure 17 est en contact, par sa face inférieure, avec la face supérieure de la couche isolante 15. L'électrode inférieure 17 est par exemple en un matériau conducteur. L'électrode inférieure 17 est par exemple en un matériau métallique. A titre d'exemple, l'électrode inférieure 17 est en titane, en nitrure de titane, en cuivre, en aluminium, en tungstène, en nickel et/ou en un mélange d'un ou plusieurs de ces matériaux.

A titre d'exemple, l'électrode inférieure 17 est commune à plusieurs cellules mémoires voisines, par exemple les cellules mémoires d'une même ligne.

L'électrode inférieure 17 est, par exemple, entourée latéralement d'une couche isolante 19 permettant d'isoler l'électrode inférieure 17 des électrodes inférieures de cellules voisines. La couche isolante 19 est par exemple en un oxyde. A titre d'exemple, la couche isolante 19 est en dioxyde de silicium.

Le dispositif électronique 11 comprend, par exemple, une couche isolante 21 traversée par un via conducteur 23. A titre d'exemple, le via conducteur 23 a une forme cylindrique comportant une face supérieure et une face inférieure de forme circulaire. A titre d'exemple, le via conducteur 23 affleure, par sa face supérieure, la face supérieure de la couche 21. Similairement, le via conducteur 23 affleure, par exemple, par sa face inférieure, la face inférieure de la couche 21. La couche isolante 21 et le via conducteur 23 recouvrent, par exemple, la face supérieure de l'électrode 17 et de la couche isolante 19. A titre d'exemple, la couche isolante 21 et le via conducteur 23 sont en contact, par leurs faces inférieures, avec la face supérieure de l'électrode inférieure 17 et de la couche isolante 19. Le via conducteur 23 est, par exemple, situé à l'aplomb de l'électrode inférieure 17. A titre d'exemple, le via conducteur 23 a un diamètre inférieur à la largeur de l'électrode inférieure 17 prise dans le plan de la figure 1C. Le via conducteur 23 est par exemple centrée sur l'électrode inférieure 17, il ne recouvre ainsi qu'une partie de la surface de la face supérieure de l'électrode inférieure 17. A titre d'exemple, le via conducteur 23 est en un matériau métallique. Le via conducteur 23 est par exemple en platine et/ou en nickel. La couche isolante 21 est, par exemple, en un oxyde. A titre d'exemple, la couche isolante 21 est en dioxyde de silicium. Le via conducteur 23 a, par exemple, une hauteur comprise entre 100 nm et 1 µm. Le via 23 a par exemple une section transverse de surface comprise entre 0,01 µm² et 5 µm².

Le dispositif électronique 11 comprend, en outre, une couche 25 d'un matériau 2D. A titre d'exemple, la couche 25 a, en vue de dessus, une forme carrée ou sensiblement carrée. La couche 25 recouvre, par exemple, la face supérieure du via conducteur 23 et de la couche isolante 21. A titre d'exemple, la couche 25 est en contact par sa face inférieure avec la face supérieure du via conducteur 23 et de la couche isolante 21. La couche 25 est par exemple située à l'aplomb du via conducteur 23. La couche 25 est par exemple centrée à l'aplomb du via conducteur 23. A titre d'exemple, la couche 25 recouvre toute la surface de la face supérieure du via conducteur 23. La couche 25 est par exemple localisée et ne recouvre, par exemple, pas toute la surface de la face supérieure de la couche isolante 21.

A titre d'exemple, la couche 25 comprend un empilement d'un ou plusieurs feuillets monoatomiques ou monomoléculaires du matériau 2D. A titre d'exemple, la couche 25 comprend un nombre de feuillets monoatomiques ou monomoléculaires inférieur à 20, par exemple inférieur à 10, par exemple inférieur à 5, par exemple inférieur à 3, par exemple inférieur à 2, par exemple égal à 1. A titre d'exemple, la couche 25 a une épaisseur de l'ordre de quelques nanomètres, par exemple comprise entre 0,1 nm et 10 nm.

La couche 25 est par exemple en un matériau 2D semiconducteur. A titre d'exemple, la couche 25 est en un dichalcogénure de métal de transition matériau ou TMD (de l'anglais " Transition Métal Dichalcogenide"), par exemple de formule MX₂ dans lequel "M" correspond à un métal de transition et "X" correspond à un chalcogène. A titre d'exemple, la couche 25 est en disulfure de molybdène (MoS₂). A titre de variante, la couche 25 correspond à un TMD dont le métal de transition est choisi dans la sixième colonne du tableau périodique des éléments. A titre de variante, la couche 25 correspond à un empilement de monocouches de plusieurs matériaux 2D différents, par exemple un empilement de monocouches de graphène et de disulfure de molybdène, ou un empilement de plusieurs TMD différents.

A titre de variante, la couche 25 est en un matériau isolant, par exemple en nitrure de bore hexagonal ou h-BN (de l'anglais " hexagonal Boron Nitride").

A titre d'exemple, la couche 25 est d'abord formée sur un substrat de croissance puis reportée sur la face supérieure de la couche isolante 21 et du via conducteur 23. A titre d'exemple, le substrat de croissance (non représenté) de la couche 25 est en dioxyde de silicium (SiO₂)ou en saphir dans le cas d'une couche 25 en disulfure de molybdène. A titre d'exemple, le substrat de croissance de la couche 25 est en saphir ou en cuivre dans le cas d'une couche 25 en h-BN.

Le dispositif électronique 11 comprend en outre une électrode supérieure 27 recouvrant entièrement la couche 25. L'électrode supérieure 27 a par exemple la forme d'une bande rectiligne s'étendant dans une direction orthogonale à la direction dans laquelle s'étend l'électrode inférieure 17. A titre d'exemple, l'électrode supérieure 27 est commune à plusieurs cellules mémoires voisines, par exemple les cellules mémoire d'une même colonne.

Dans l'exemple représenté, l'électrode supérieure 27 recouvre entièrement la face supérieure et l'ensemble des flancs de la couche 25. L'électrode supérieure 27 est par exemple en contact avec toute la surface supérieure et toute la surface des flancs de la couche 25. A titre d'exemple, l'électrode supérieure 27 recouvre en outre la couche 19 au voisinage de la couche 25. A titre d'exemple, l'électrode supérieure 27 recouvre la couche 19 de part et d'autre de la couche 25 sur une largeur l supérieure à 1 nm, par exemple supérieure à 10 nm, par exemple supérieure à 20 nm, par exemple supérieure à 50 nm, par exemple supérieure à 100 nm, par exemple supérieure à 200 nm, par exemple supérieure à 300 nm, par exemple supérieure à 400 nm. A titre d'exemple, l'électrode supérieure 27 est en un matériau conducteur. A titre d'exemple, l'électrode supérieure 27 est en un matériau métallique. L'électrode supérieure 27 est par exemple en nitrure de titane. L'électrode supérieure 27 a, par exemple, une épaisseur comprise entre 50 nm et 300 nm, par exemple de l'ordre de 100 nm.

Similairement à ce qui a été décrit ci-avant en lien avec l'électrode 17, l'électrode supérieure 27 est, par exemple, entourée d'une couche isolante (non représentée) permettant d'isoler l'électrode supérieure 27 des cellules mémoires d'une même colonne de l'électrode supérieure 27 des cellules mémoires des colonnes voisines. Cette couche isolante est par exemple en un oxyde. A titre d'exemple, cette couche isolante est en dioxyde de silicium.

A titre d'exemple, la couche 25 est située en vis à vis de l'intersection de l'électrode inférieure 17 et de l'électrode supérieure 27.

Dans le mode de réalisation des figures 1A à 1C, l'électrode supérieure 27 forme une couche d'encapsulation recouvrant entièrement la face supérieure et les flancs de la couche 25.

A titre d'exemple, l'électrode supérieure 27 est formée par un procédé de dépôt localisé par décollage ("lift-off" en anglais). La formation de l'électrode supérieure 27 comprend ainsi une étape de dépôt d'une couche sacrificielle, par exemple en résine, sur la face supérieure de la couche isolante 21 et de la couche 25. La couche sacrificielle est par exemple en polyméthacrylate de méthyle ou PMMA (de l'anglais "poly(methyl methacrylate)"). A l'issue du dépôt de la couche sacrificielle, celle-ci est retirée localement aux endroits où l'on souhaite former l'électrode supérieure 27. Une étape de dépôt du matériau de l'électrode supérieure 27 est par la suite réalisée sur l'ensemble de la face supérieure de la structure, c'est-à-dire sur la face supérieure de la couche sacrificielle et dans les ouvertures réalisées dans cette même couche. La dernière étape consiste en le retrait de la couche sacrificielle conduisant au retrait de la couche du matériau de l'électrode supérieure 27 lorsque celle-ci est formée sur la couche sacrificielle.

Un avantage du présent mode de réalisation est lié au fait que l'électrode supérieure 27 forme une couche d'encapsulation recouvrant entièrement la face supérieure et les flancs de la couche 25. Ceci permet d'éviter la délamination de la couche 25 lors de la formation de l'électrode supérieure 27 au contact de celle-ci, et plus particulièrement lors du retrait de la couche sacrificielle lorsque l'électrode supérieure 27 est formée par un procédé de dépôt localisé par décollage ("lift-off" en anglais). Les inventeurs ont en effet constaté que les contraintes exercées par le métal de l'électrode supérieure 27 entraînent une délamination de la couche 25 lorsque les flancs de la couche 25 sont laissés libres, et que les flancs de l'électrode 27 sont donc en contact avec la face supérieure de la couche 25. La zone de contact entre la couche 25 et les flancs de la couche métallique 27 est l'endroit où s'initie la délamination.

Un autre avantage du présent mode de réalisation est qu'il permet de protéger la couche 25 des attaques extérieures, par exemple lors d'étapes de procédé ultérieures comme des étapes d'oxydation.

Encore un autre avantage du présent mode de réalisation est qu'il permet d'augmenter l'épaisseur de l'électrode supérieure 27 afin d'en augmenter sa conductivité, sans augmenter le risque de délamination.

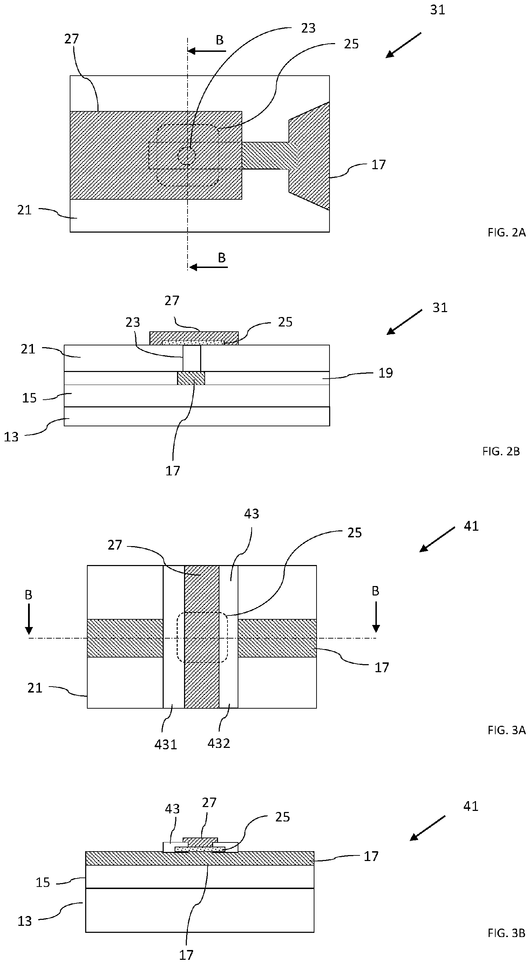

La figure 2A et la figure 2B représentent respectivement une vue de dessus et une vue en coupe, partielles et schématiques, d'un dispositif électronique 31 selon un deuxième mode de réalisation, la figure 2B correspondant à la vue en coupe selon le plan de coupe BB illustré en figure 2A.

Le dispositif électronique 31 correspond, par exemple, à un commutateur radiofréquence ou commutateur RF.

Le dispositif électronique 31 est par exemple en partie structurellement similaire au dispositif électronique 11 illustré en figures 1A à 1C à la différence près de la géométrie de l'électrode inférieure 17 et l'électrode supérieure 27.

A titre d'exemple, dans le dispositif électronique 31, les électrodes inférieure 17 et supérieure 27 s'étendent, au moins localement, dans la même direction. A titre d'exemple, le dispositif électronique 31 comprend une région dans laquelle une extrémité de l'électrode inférieure 17 s'étend à l'aplomb d'une extrémité de l'électrode supérieure 27 et dans laquelle les électrodes inférieure 17 et supérieure 27 se prolongent dans la même direction mais dans deux sens opposés.

En figure 2A, les électrodes inférieure 17 et supérieure 27 sont par exemple représentées l'une à l'aplomb de l'autre dans une partie centrale, l'électrode inférieure 17 se prolongeant vers la droite dans l'orientation de la figure 2A alors que l'électrode supérieure 27 se prolonge vers la gauche. A titre d'exemple, dans la région d'aplomb des électrodes 27 et 17, l'électrode inférieure 17 a une largeur inférieure à la largeur de l'électrode supérieure 27. Dans cette région, la couche 25 a, par exemple, une largeur prise dans le plan de la figure 2B, supérieure à la largeur de l'électrode inférieure 17 et s'étend, par exemple, au-delà de l'aplomb de l'électrode inférieure 17. Les modes de réalisation décrits ne se limitent toutefois pas à cette configuration particulière.

Dans le dispositif électronique 31, la couche 25 est comprise entre l'électrode supérieure 27 et l'électrode inférieure 17 et est ainsi située en vis-à-vis de l'extrémité de l'électrode supérieur 27 et en vis-à-vis de l'extrémité de l'électrode inférieure 17.

Dans ce mode de réalisation et similairement à ce qui a été décrit en relation avec le premier mode de réalisation illustré en figures 1A à 1C, l'électrode supérieure 27 recouvre entièrement la surface supérieure et les flancs de la couche 25 de façon à former une couche d'encapsulation permettant d'éviter la délamination de la couche 25 lors de la formation de l'électrode 27.

La figure 3A et la figure 3B représentent respectivement une vue de dessus et une vue en coupe, partielles et schématiques, d'un dispositif électronique 41 selon un troisième mode de réalisation la figure 3B correspondant à la vue en coupe selon le plan de coupe BB illustré en figure 3A.

Le dispositif électronique 41 est similaire au dispositif électronique 11 illustré en figures 1A à 1C à la différence près qu'il ne comprend pas, entre les électrodes inférieure 17 et supérieure 27, de via conducteur 23 et que l'électrode supérieure 27 ne recouvre pas toute la surface supérieure de la couche 25.

Le dispositif électronique 41 illustré en figures 3A et 3B correspond, par exemple similairement à ce qui a été décrit en relation avec les figures 1A à 1C, à une cellule mémoire.

Dans le dispositif électronique 41, l'électrode inférieure 17 est par exemple en contact, par sa face supérieure, avec la face inférieure de la couche 25.

A titre d'exemple, l'électrode supérieure 27 est formée à l'aplomb de la couche 25 avec une largeur inférieure à la largeur de la couche 25 prises dans le plan de la figure 3B. L'électrode supérieure 27 est ainsi formée à l'aplomb de la couche 25 sans recouvrir deux bandes périphériques de la couche 25 située de part et d'autre de l'électrode supérieure 27.

A titre d'exemple, le dispositif électronique 41 comprend une couche isolante 43 formée de part et d'autre de l'électrode supérieure 27 sur les parties périphériques de la couche 25 laissées libres par l'électrode supérieure 27. A titre d'exemple, la couche isolante 43 s'étend dans la même direction que l'électrode supérieure 27, c'est-à-dire orthogonalement à l'électrode inférieure 17. A titre d'exemple, la couche isolante 43 comprend deux portions. La couche isolante 43 s'étend par exemple de part et d'autre de l'électrode supérieure 27 à partir des flancs de l'électrode supérieure 27 en se prolongeant sur et en contact avec la face supérieure de la couche 25 non recouverte par l'électrode 27. A titre d'exemple, la couche isolante 43 se prolonge jusqu'à recouvrir les flancs de la couche 25 non recouverts par l'électrode supérieure 27. A titre d'exemple, la couche isolante 45 se prolonge en outre sur une partie de la face supérieure de l'électrode inférieure 17 et de la couche 19.

Ainsi, dans cet exemple, une première portion 431 de la couche isolante 43 est en contact avec le flanc gauche de l'électrode supérieure 27 dans l'orientation de la figure 3A et est formée au contact d'une partie de la couche 25 non recouverte par l'électrode supérieure 27. A titre d'exemple, la première portion isolante 431 s'étend au delà du vis-à-vis de la couche 25 et se prolonge sur la face supérieure du dispositif en recouvrant le flanc de la couche 25. A titre d'exemple, la portion 431 de la couche 43 s'étend sur une partie de l'électrode inférieure 17 et de la couche 19 située au voisinage de l'électrode supérieure 27.

Similairement, une deuxième portion 432 de la couche isolante 43 est par exemple en contact avec le flanc droit de l'électrode supérieure 27 dans l'orientation de la figure 3A et est formée au contact d'une partie de la couche 25 non recouverte par l'électrode supérieure 27. A titre d'exemple, la deuxième portion isolante 433 s'étend au delà du vis-à-vis de la couche 25 et se prolonge sur la face supérieure du dispositif en recouvrant le flanc de la couche 25. A titre d'exemple, la portion 433 de la couche 43 s'étend sur une partie de l'électrode inférieure 17 et de la couche 19 située au voisinage de l'électrode supérieure 27.

A titre d'exemple, la couche isolante 43 est en un oxyde, par exemple en oxyde de silicium.

La couche isolante 43 est par exemple formée avant la formation de l'électrode supérieure 27. A titre d'exemple, la couche isolante 43 est formée pleine plaque de façon à recouvrir l'ensemble de la face supérieure de l'électrode inférieure 17 et la face supérieure de la couche 25. La couche isolante 43 est par exemple formée au contact de l'électrode inférieure 17 et de la couche 25. La couche isolante 43 est par la suite, par exemple, retirée localement de façon à n'être conservée qu'en vis-à-vis de deux bandes périphériques de la couche 25, dans la direction orthogonale à la direction de l'électrode inférieure 17. A titre d'exemple, à l'issue de cette étape, la couche isolante 43 n'est conservée que sur deux portions s'étendant simultanément sur la couche 25 et la face supérieure de la couche 19 et l'électrode inférieure 17. Autrement dit, la couche isolante 43 est retirée en vis à vis d'une bande centrale de la couche 25. L'électrode supérieure 27 est par exemple formée après la formation de la couche isolante 43 par un procédé de dépôt localisé par décollage. L'électrode supérieure 27 est par exemple formée de façon à ne subsister qu'entre les deux portions de la couche 43. A titre d'exemple, l'électrode supérieure 27 est formée avec une épaisseur supérieure à l'épaisseur de la couche 43. L'électrode supérieure 27 se prolonge par exemple sur et en contact avec une partie de la face supérieure de la couche 43.

Dans le mode de réalisation des figures 3A et 3B, l'électrode supérieure 27 et la couche isolante 43 forment ensemble une couche d'encapsulation recouvrant entièrement la face supérieure et les flancs de la couche 25. Cette couche d'encapsulation, comprenant l'électrode supérieure 27, permet d'éviter la délamination de la couche 25 lors de la formation de l'électrode 27. La couche isolante 43 permet notamment d'éviter que l'électrode supérieure 27 et l'électrode inférieure 17 ne soient en contact direct l'une avec l'autre.

Un avantage du présent mode de réalisation est qu'il permet de réduire la largeur de l'électrode supérieure 27 et ainsi diminuer le coût matière d'un tel dispositif.

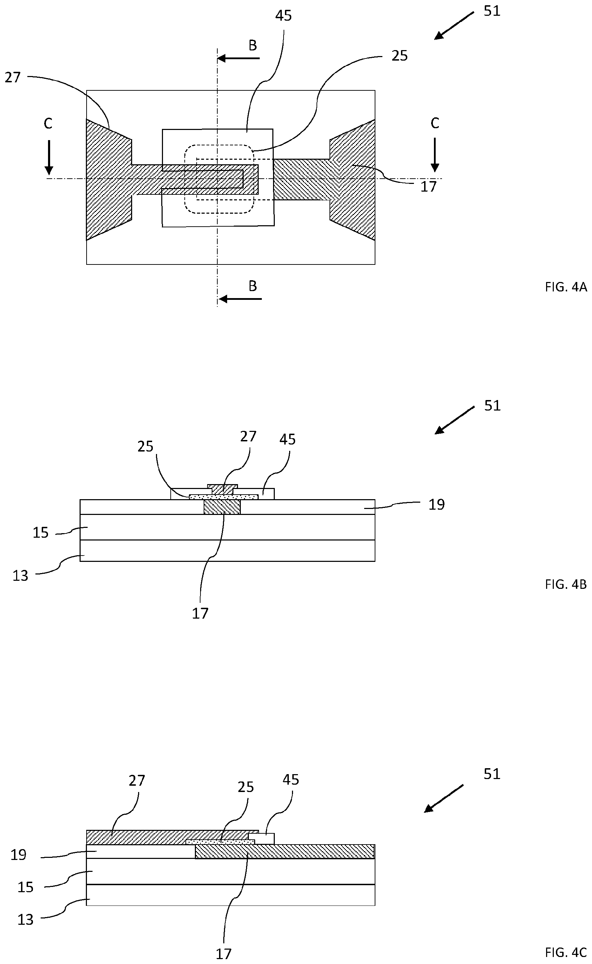

La figure 4A, la figure 4B et la figure 4C représentent respectivement une vue de dessus et deux vues en coupe, partielles et schématiques, d'un dispositif électronique 51 selon un quatrième mode de réalisation, la figure 4B correspondant à la vue en coupe selon le plan de coupe BB illustré en figure 4A et la figure 4C correspondant à la vue en coupe selon le plan de coupe CC illustré en figure 4A.

Le dispositif électronique 51 correspond, par exemple, à un commutateur radiofréquence ou commutateur RF.

Le dispositif électronique 51 est par exemple en partie structurellement similaire au dispositif électronique 41 illustré en figures 3A à 3C. Le dispositif électronique 51 diffère du dispositif 41 notamment par la géométrie de l'électrode inférieure 17 et de l'électrode supérieure 27.

A titre d'exemple, dans le dispositif électronique 51, et similairement à ce qui est représenté qui a été décrit en relation avec les figures 2A et 2B, les électrodes inférieure 17 et supérieure 27 s'étendent, au moins localement, dans la même direction. Le dispositif électronique 51 comprend par exemple une région dans laquelle une extrémité de l'électrode inférieure 17 s'étend à l'aplomb d'une extrémité de l'électrode supérieure 27 et dans laquelle les électrodes inférieure 17 et supérieure 27 se prolongent dans la même direction mais dans deux sens opposés.

Dans le dispositif électronique 51, la couche 25 est comprise entre l'électrode supérieure 27 et l'électrode inférieure 17 et plus particulièrement entre les extrémités respectives des électrodes supérieure 27 et inférieure 17.

Dans le mode de réalisation des figures 4A à 4C, la couche 25 a, par exemple, une largeur prise dans le plan de la figure 4B, supérieure à la largeur de l'électrode inférieure 17. La couche 25 s'étend dans ce plan par exemple au-delà de l'aplomb de l'électrode inférieure 17 en se prolongeant sur une partie de la face supérieure de la couche 19 au voisinage de l'électrode inférieure 17.

A titre d'exemple, l'électrode supérieure 27 est en contact avec la couche 25. A titre d'exemple, l'électrode supérieure 27 recouvre la face supérieure de la couche 25 en laissant trois parties périphériques de la couche 25 libres et non recouvertes par l'électrode supérieure 27.

Similairement à ce qui a été décrit en relation avec les figures 3A et 3B, l'électrode supérieure 27 est entourée, en vis-à-vis de la couche 25, par une couche isolante 45. La couche isolante 45 est par exemple similaire dans sa composition à la couche isolante 43 illustrée en figures 3A et 3B. Dans le mode de réalisation des figures 4A à 4C, la couche isolante 45 a la forme d'un "U" entourant l'extrémité de l'électrode supérieure 27. A titre d'exemple, la couche 45 ne se prolonge pas le long de l'électrode supérieure 27 comme cela a été décrit en relation avec les figures 3A et 3B.

La couche isolante 45 s'étend par exemple à partir des trois flancs de l'électrode supérieure 27 situés en vis-à-vis de la couche 25, en se prolongeant en vis-à-vis de la couche 25 de façon à recouvrir les parties de la couche 25 non recouvertes par l'électrode supérieure 27. La couche 45 recouvre en outre les flancs de la couche 25 non recouverts par l'électrode supérieure 27 et se prolonge sur une partie de la face supérieure de la couche 19 au voisinage de la couche 25. A titre d'exemple, dans le dispositif électronique 51, l'électrode supérieure 27 et l'électrode inférieure 17 ne sont pas en contact direct l'une avec l'autre.

Là encore, la couche isolante 45 et l'électrode supérieure 27 forment une couche d'encapsulation recouvrant entièrement la face supérieure et les flancs de la couche 25 et permettant d'éviter la délamination de la couche 25 lors de la formation de l'électrode supérieure 27.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique comportant un empilement comportant, dans l'ordre à partir de la face supérieure d'un substrat (13), une première électrode (17), une couche d'un matériau 2D (25), et une deuxième électrode (27), dans lequel la surface supérieure et les flancs de la couche du matériau 2D (25) sont entièrement recouvertes par une couche d'encapsulation (27 ; 27, 43 ; 27, 45) comprenant au moins la deuxième électrode (27).

2. Dispositif selon la revendication 1, dans lequel la couche d'encapsulation (27) présente une face inférieure coplanaire avec une face inférieure de la couche du matériau 2D (25).

3. Dispositif selon la revendication 1, dans lequel la couche d'encapsulation (27) est constituée uniquement de la deuxième électrode (27).

4. Dispositif selon la revendication 3, comprenant, entre ladite couche en le matériau 2D (25) et la première électrode (17), une couche isolante (21) et un via conducteur (23) traversant la couche isolante (21), le via conducteur (23) étant en contact par une première face avec ladite couche en le matériau 2D (25) et par une deuxième face, opposée à la première face, avec la première électrode (17).

5. Dispositif électronique selon la revendication 1, dans lequel la couche d'encapsulation (27, 43 ; 27, 45) comprend une couche isolante (43 ; 45) sur et au contact avec au moins une partie des flancs de la couche (25) du matériau 2D.

6. Dispositif selon la revendication 5, dans lequel ladite couche en le matériau 2D (25) est en contact par une première face avec la couche d'encapsulation (27, 43) et par une deuxième face, opposée à la première face, avec la première électrode (77).

7. Dispositif selon la revendication 5 ou 6, dans lequel la deuxième électrode (27) est en contact avec seulement une partie de la couche en le matériau 2D (25).

8. Dispositif selon l'une quelconque des revendications 1 à 7, dans lequel le matériau 2D est semiconducteur.

9. Dispositif selon l'une quelconque des revendications 1 à 8, dans lequel le matériau 2D est à base d'un dichalcogénure de métal de transition.

10. Dispositif selon la revendication 9, dans lequel le matériau 2D est à base de disulfure de molybdène.

11. Dispositif selon l'une quelconque des revendications 1 à 10, dans lequel la couche en le matériau 2D (25) correspond à un empilement de plusieurs monocouches de disulfure de molybdène et de graphène.

12. Dispositif selon l'une quelconque des revendications 1 à 7, dans lequel le matériau 2D est à base de nitrure de bore hexagonal.

13. Procédé de fabrication d'un dispositif électronique comportant la formation d'un empilement comportant les étapes successives suivantes :
- former une première électrode (17) sur la face supérieure d'un substrat (13) ;
- former une couche d'un matériau 2D (25) sur la face supérieure de la première électrode (17) ; et
- former une deuxième électrode (27) sur la face supérieure de la couche en le matériau 2D (25), de sorte que la face supérieure et les flancs de la couche du matériau 2D (25) soient entièrement recouvertes par une couche d'encapsulation (27 ; 27, 43 ; 27, 45) comprenant au moins la deuxième électrode (27).
